# EUROPEAN PATENT APPLICATION

(11) **EP 2 487 934 A1**
(43) Date of publication of application: **15.08.2012**
(21) Application number: 10821560.9
(22) Date of filing: 19.03.2010
(51) Int. Cl.: H04R 17/00, H01L 41/047

(54) **PIEZOELECTRIC FILM ULTRASONIC SENSOR ELECTRODE**

(30) Priority: 10.10.2009 CN 200910190786
(71) Applicant: Measurement Specialties (China) Ltd., Shenzhen, Guangdong 518107 (CN)
(72) Inventor: WANG, Wanjie, Shenzhen Guangdong 518107 (CN)
(74) Representative: Tilmann, Max Wilhelm
(86) International application number: PCT/CN2010/071144
(87) International publication number: WO 2011/041951

(57) **Abstract**

The present invention relates to the field of piezo transducer technologies, and provides an electrode of a piezo film ultrasonic transducer having a piezo film. The piezo film includes a working portion and a lead-out portion. The electrode of a piezo film ultrasonic transducer includes: a first base plated electrode layer that is plated on a same surface of the working portion and the lead-out portion of the piezo film; a first conductive layer coated on the other surface of the first base plated electrode layer; and a second base plated electrode layer plated on the other surface of the working portion and the lead-out portion. After a base electrode layer is plated on a surface of the lead-out portion and the working portion of the piezo film, a conductive layer is coated on the other surface of the electrode layer. Therefore, when the conductive layer is coated to a region of the electrode layer that is on the lead-out portion, the reliability of connections between electrodes on the surface of the lead-out portion and electrodes of a PCB can be improved.

## Description

### BACKGROUND OF THE INVENTION

### 1. Technical Field

The present invention relates to the field of piezo transducer technologies, and more particularly, to an electrode of a piezo film ultrasonic transducer.

### 2. Description of Related Art

Nowadays, ultrasonic transducers adopting a piezo film as a piezo material have been widely used in fields of industries and national defense. Design of electrodes is a particularly important factor in the design and fabrication of the ultrasonic transducers, and directly affects and determines performances of the transducers.

Electrodes of conventional ultrasonic transducers are usually formed by screen printing a conductive material on a surface of a piezo material. Specifically, a conductive material (e.g., silver powders, carbon powders or silver-carbon mixture powders) with a high conductivity is printed on the surface of the piezo material through screen printing to form electrodes. This is advantageous in that the electrodes can be printed into any form, the process is simple, and the electrodes obtained have a small resistance and reliable and stable performances. However, use of the screen printing process makes it difficult to make the electrodes very thin, and the thickness of the electrodes is typically 8∼12 µm. However, for the piezo film ultrasonic transducers, it is necessary to reduce the load weight on the piezo material in order to achieve higher acoustic pressure sensitivity under the same driving conditions. Therefore, the thick and heavy electrodes that are obtained through screen printing have limited the acoustic pressure sensitivity of the transducers.

Accordingly, another kind of electrodes of an ultrasonic transducer has been proposed in the prior art, which are formed through vacuum sputtering on a surface of a piezo material. Specifically, plating is carried out in large areas on both sides of the piezo material to form plated layers. The plated layers are generally made of a material with a high conductivity such as aluminum (Al), copper (Cu), nickel (Ni) or gold (Au). The plated layers just serve as electrodes of the ultrasonic transducers. This kind of electrodes is very light and thin with a typical thickness of the whole electrode layer being about 400 angstroms to 1000 angstroms. Therefore, the acoustic pressure sensitivity in the kind of electrodes can be improved as compared to electrodes formed through screen printing.

Because the ultrasonic transducers are used under high-voltage and high-frequency driving conditions, it is required that electrodes of the ultrasonic transducers shall be able to withstand a large high-frequency current during operation of the transducers. However, electrodes formed through vacuum sputtering are very light and thin and have nonuniform resistances on surfaces thereof. Consequently, under the high-voltage and high-frequency driving conditions, the large high-frequency instantaneous current tends to cause evaporation or peeling off of the plated layers and failure of the electrodes. This makes it impossible for the ultrasonic transducers to operate for a long time and shortens the service life of the ultrasonic transducers.

### BRIEF SUMMARY OF THE INVENTION

### Technical problems

An objective of embodiments of the present invention is to provide an electrode of a piezo film ultrasonic transducer, which is intended to solve the problems in the prior art that: because plated layers serving as electrodes that are formed through vacuum sputtering on a surface of a piezo material are very light and thin and have nonuniform resistances on surfaces thereof, the large high-frequency instantaneous current tends to cause evaporation or peeling off of the plated layers and shortens the service life of the ultrasonic transducers under the high-voltage and high-frequency driving conditions.

### Technical solutions

The embodiments of the present invention are achieved as follows. An embodiment of the present invention provides an electrode of a piezo film ultrasonic transducer having a piezo film. The piezo film includes a working portion and a lead-out portion integrally formed with the working portion. The electrode of a piezo film ultrasonic transducer includes:
- a first base plated electrode layer that is plated on a same surface of the working portion and the lead-out portion of the piezo film;
- a first conductive layer coated on the other surface of the first base plated electrode layer; and
- a second base plated electrode layer plated on the other surface of the working portion and the lead-out portion,
wherein a region of the first base plated electrode layer and a region of the second base plated electrode layer that are plated on the lead-out portion are used to connect electrodes of a printed circuit board (PCB) that includes a drive circuit of the piezo film ultrasonic transducer respectively, and the region of the first base plated electrode layer that is plated on the lead-out portion is adapted to introduce a current into or out of a region of the first base plated electrode layer that is plated on the working portion; the region of the second base plated electrode layer that is plated on the lead-out portion is adapted to introduce a current into or out of a region of the second base plated electrode layer that is plated on the working portion; and polarities of the first base plated electrode layer and the second base plated electrode layer are opposite to each other.

An embodiment of the present invention further provides an electrode of a piezo film ultrasonic transducer having a piezo film. The piezo film includes a working portion and a lead-out portion integrally formed with the working portion. The electrode of a piezo film ultrasonic transducer includes:
- a first base plated electrode layer that is plated on a surface of the working portion of the piezo film;
- a first conductive layer coated on a surface of the lead-out portion that is the same as the surface of the working portion;
- a second base plated electrode layer plated on the other surface of the working portion; and
- a second conductive layer coated on the other surface of the lead-out portion,
wherein the first conductive layer and the second conductive layer are used to connect electrodes of a PCB that includes a drive circuit of the piezo film ultrasonic transducer respectively, the first conductive layer is adapted to introduce a current into or out of the first base plated electrode layer, and the second conductive layer is adapted to introduce a current into or out of the second base plated electrode layer; and polarities of the first base plated electrode layer and the second base plated electrode layer are opposite to each other.

An embodiment of the present invention further provides an electrode of a piezo film ultrasonic transducer having a piezo film. The piezo film includes a working portion and a lead-out portion integrally formed with the working portion. The electrode of a piezo film ultrasonic transducer includes:
- a first base plated electrode layer that is plated on a surface of the working portion of the piezo film;
- a first conductive layer coated on a surface of the lead-out portion that is the same as the surface of the working portion; and
- a second base plated electrode layer plated on the other surface of the working portion and the lead-out portion,
wherein the first conductive layer and a region of the second base plated electrode layer that is plated on the lead-out portion are used to connect electrodes of a PCB that includes a drive circuit of the piezo film ultrasonic transducer respectively, the first conductive layer is adapted to introduce a current into or out of the first base plated electrode layer, the region of the second base plated electrode layer that is plated on the lead-out portion is adapted to introduce a current into or out of a region of the second base plated electrode layer that is plated on the working portion, and polarities of the first base plated electrode layer and the second base plated electrode layer are opposite to each other.

### Benefits

In the embodiments of the present invention, after a base electrode layer is plated on a surface of the lead-out portion and the working portion of the piezo film, a conductive layer is coated on the other surface of the electrode layer. Therefore, when the conductive layer is coated to a region of the electrode layer that is on the lead-out portion, the reliability of connections between electrodes on the surface of the lead-out portion and electrodes of a PCB can be improved.

### BRIEF DESCRIPTION OF THE SEVERAL VIEWS OF THE DRAWINGS

- Fig. 1:: is a schematic view illustrating a side structure of an electrode of a piezo film ultrasonic transducer and a piezo film according to a first embodiment of the present invention;
- Fig. 2:: is a schematic view illustrating a surface structure of the electrode of a piezo film ultrasonic transducer and the piezo film according to the first embodiment of the present invention;
- Fig. 3:: is a schematic structural view illustrating an electrode of a piezo film ultrasonic transducer and a piezo film according to a fourth embodiment of the present invention when being disassembled;
- Fig. 4:: is a schematic view illustrating a surface structure of the electrode of a piezo film ultrasonic transducer and the piezo film according to the fourth embodiment of the present invention;
- Fig. 5:: is a schematic view illustrating a surface structure of a positive electrode in Fig. 4; and
- Fig. 6:: is a schematic view illustrating a surface structure of a negative electrode in Fig. 4.

### DETAILED DESCRIPTION OF THE INVENTION

In order to make the objectives, technical solutions and advantages of the present invention more clearly, the present invention will be further detailed with reference to the attached drawings and embodiments hereinafter. It shall be understood that, the embodiments described herein are only intended to illustrate but not to limit the present invention.

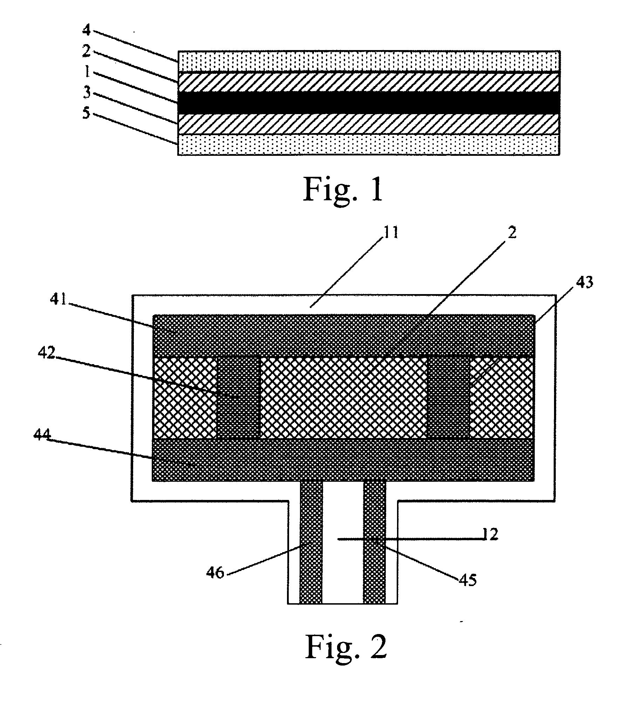

In the prior arts, during fabrication of a piezo film ultrasonic transducer, a piezo film is stretched to a certain thickness at a certain ratio, and then a plated layer serving as an electrode of the piezo film ultrasonic transducer is formed on a surface of the piezo film through vacuum sputtering. However, the surface of the piezo film resulting from the stretching process is uneven and becomes wavy or jagged in the stretching direction. Thus, after the subsequent vacuum sputtering process and fabrication of the electrode, the plated layer on the surface of the piezo film will have nonuniform thicknesses, and consequently, the electrode on the piezo film will have nonuniform resistances on the surface thereof. If the piezo film ultrasonic transducer thus formed is used under high-voltage driving conditions, then the nonuniform surface resistances of the electrode on the piezo film will cause nonuniform flow of the high-frequency current on the surface, particularly on a lead-out portion of the piezo film for leading in or leading out a current, and the large instantaneous current applied for a long time will cause the plated layer of the piezo film that serves as the electrode to generate heat and then peel off or evaporate. Additionally, in actual applications, the lead-out portion is usually connected to a copper electrode of a printed circuit board (PCB) including a drive circuit through crimping, and the surface of the copper electrode of the PCB becomes unsmooth because of the chemical etching process, the copper sheet calendering process or the like. This causes multiple point connections rather than surface connections on the surface of the lead-out portion and the copper electrode when the lead-out portion is connected with the PCB. As the large high-frequency current resulting from the high drive voltage flows through the point connections, portions of the plated layer that are adjacent to the point connections are tend to evaporate after a long time period, which shortens the service life of the transducer. In view of the aforesaid technical problems, the present invention applies a conductive layer on the surface of the lead-out portion of the piezo film or, after plating a base electrode layer on the surface of the lead-out portion of the piezo film, applies a conductive layer on the other surface of the electrode layer. As the conductive layer is coated to a region of the electrode layer that is on the lead-out portion, the reliability of connections between electrodes on the surface of the lead-out portion and electrodes of the PCB can be improved. Fig. 1 is a schematic view illustrating a side structure of an electrode of a piezo film ultrasonic transducer and a piezo film according to a first embodiment of the present invention; and Fig. 2 is a schematic view illustrating a surface structure of the electrode of a piezo film ultrasonic transducer and the piezo film according to the first embodiment of the present invention. For convenience of description, only those related to the embodiment of the present invention are shown.

Referring to Fig. 1 and Fig. 2, the piezo film 1 includes a working portion 11 and a lead-out portion 12 integrally formed with the working portion 11. The electrode of a piezo film ultrasonic transducer according to the first embodiment of the present invention includes: a first base plated electrode layer 2 that is plated on a same surface of the working portion 11 and the lead-out portion 12 of the piezo film 1; a first conductive layer 4 coated on the other surface of the first base plated electrode layer 2; and a second base plated electrode layer 3 plated on the other surface of the working portion 11 and the lead-out portion 12 of the piezo film 1. The electrode of a piezo film ultrasonic transducer may further include a second conductive layer 5 coated on the other surface of the second base plated electrode layer 3.

A region of the first base plated electrode layer 2 and a region of the second base plated electrode layer 3 that are plated on the lead-out portion 12 are used to connect electrodes of a PCB that includes a drive circuit of the piezo film ultrasonic transducer respectively. The region of the first base plated electrode layer 2 that is plated on the lead-out portion 12 is adapted to introduce a current into or out of a region of the first base plated electrode layer 2 that is plated on the working portion 11. The region of the second base plated electrode layer 3 that is plated on the lead-out portion 12 is adapted to introduce a current into or out of a region of the second base plated electrode layer 3 that is plated on the working portion 11. The first conductive layer 4 may be coated in a preset form to the region of the first base plated electrode layer 2 that is on the working portion 11, and may also be coated in a preset form to the region of the first base plated electrode layer 2 that is on the lead-out portion 12. Likewise, the second conductive layer 5 may be coated in a preset form to the region of the second base plated electrode layer 3 that is on the working portion 11, and may also be coated in a preset form to the region of the second base plated electrode layer 3 that is on the lead-out portion 12. Polarities of the first base plated electrode layer 2 and the second base plated electrode layer 3 are opposite to each other. For example, when the first base plated electrode layer 2 is of a positive polarity, the second base plated electrode layer 3 is of a negative polarity.

Because a conductive layer is coated on the other surface of the first base plated electrode layer 2 and/or the other surface of the second base plated electrode layer 3, the reliability of connections between electrodes on the surface of the lead-out portion 12 and the electrodes of the PCB can be improved when the conductive layer is coated to the region of the first base plated electrode layer 2 and/or the second base plated electrode layer 3 that is on the lead-out portion 12. Meanwhile, when the conductive layer is coated to the region of the first base plated electrode layer 2 and/or the second base plated electrode layer 3 that is on the working portion 11, the current carrying capability of electrodes on the surface of the working portion 11 can be increased and thus, the reliability of operation of the electrodes can be improved.

More specifically, the first base plated electrode layer 2 and/or the second base plated electrode layer 3 may be formed by forming a plated layer on the surface of the piezo film 1 through vacuum sputtering or chemical plating and then patterning the plated layer into a preset form through use of a laser or through chemical etching. When both the first base plated electrode layer 2 and the second base plated electrode layer 3 are a plated layer of a preset form formed on the surface of the piezo film 1 through vacuum sputtering or chemical plating, the plated layer acting as the first base plated electrode layer 2 and the plated layer acting as the second base plated electrode layer 3 can be arranged symmetrically or unsymmetrically with respect to the piezo film 1. The first conductive layer 4 may be a conductive substance coated on the other surface of the first base plated electrode layer 2 along a stretching direction of the piezo film 1 or a direction perpendicular to the stretching direction of the piezo film 1 through screen printing, spraying or the like; and the second conductive layer 5 may be a conductive substance coated on the other surface of the second base plated electrode layer 3 along the stretching direction of the piezo film 1 or the direction perpendicular to the stretching direction of the piezo film 1 through screen printing, spraying or the like. The conductive substance shall have a certain flexibility, a loose material structure and a large particle size, e.g., a soft conductive substance such as silver powders, carbon powders, silver-carbon mixture powders, a conductive rubber, a conductive glue, a conductive adhesive tape, a metal foil, or a metal foil on a flexible PCB.

Further, the piezo film 1 is made of a polyvinylidene fluoride (PVDF) polymer. Of course, other crystalline materials that can provide a piezo effect may also be adopted in actual implementations.

Additionally, as shown in Fig. 2, the application position of the first conductive layer 4 on the first base plated electrode layer 2 is illustrated by taking the surface on which the first conductive layer 4 is located as an example. Specifically, the first base plated electrode layer 2 includes a rectangular region coated on a surface of the working portion 11 of the piezo film 1 and a ribbon-like region coated on a surface of the lead-out portion 12 of the piezo film 1. The ribbon-like region extends from a long side of the rectangular region. The first base plated electrode layer 2 may be coated on a first strip region 41 extending into the rectangular region along the long side of the rectangular region, and/or a second strip region 44 extending into the rectangular region along the other long side of the rectangular region, and/or a third strip region 42 that is between the first strip region 41 and the second strip region 44 of the rectangular region and adjacent to a short side of the rectangular region, and/or a fourth strip region 43 that is between the first strip region 41 and the second strip region 44 of the rectangular region and adjacent to the other short side of the rectangular region, and/or a fifth strip region 45 that is at a side of the tape region and extends along the corresponding long side of the rectangular region, and/or a sixth strip region 46 that is at the other side of the tape region and extends along the corresponding long side of the rectangular region. The first strip region 41 and the second strip region 44 do not contact with each other, the third strip region 42 and the fourth strip region 43 do not contact with each other, and the fifth strip region 45 and the sixth strip region 46 do not contact with each other. The application position of the second conductive layer 5 on the second base plated electrode layer 3 is identical to or similar to the application position of the first conductive layer 4 on the first base plated electrode layer 2, and thus will not be further described herein.

An embodiment of the present invention further provides a piezo film ultrasonic transducer, which includes a piezo film and an electrode of a piezo film ultrasonic transducer that is coated on a surface of the piezo film. The electrode of a piezo film ultrasonic transducer is connected with a PCB that includes a drive circuit of the piezo film ultrasonic transducer, and is the same as the aforesaid electrode of a piezo film ultrasonic transducer.

A second embodiment of the present invention further provides an electrode of a piezo film ultrasonic transducer. The second embodiment of the present invention differs from the first embodiment in that, the electrode of a piezo film ultrasonic transducer includes: a first base plated electrode layer 2 that is plated on a surface of the working portion 11 of the piezo film 1; a first conductive layer 4 coated on a surface of the lead-out portion 12 that is the same as the surface of the working portion 11; a second base plated electrode layer 3 plated on the other surface of the working portion 11 of the piezo film 1; and a second conductive layer 5 coated on the other surface of the lead-out portion 12. The first conductive layer 4 and the second conductive layer 5 are used to connect electrodes of a PCB that includes a drive circuit of the piezo film ultrasonic transducer respectively. The first conductive layer 4 is adapted to introduce a current into or out of the first base plated electrode layer 2; the second conductive layer 5 is adapted to introduce a current into or out of the second base plated electrode layer 3; and polarities of the first base plated electrode layer 2 and the second base plated electrode layer 3 are opposite to each other.

Likewise, because a conductive layer is coated on the lead-out portion 12, the reliability of connections between electrodes on the surface of the lead-out portion 12 and the electrodes of the PCB can be improved.

Furthermore, the electrode of a piezo film ultrasonic transducer according to this embodiment of the present invention may further include a conductive layer coated on the other surface of the first base plated electrode layer 2 and/or the other surface of the second base plated electrode layer 3 so as to further increase the current carrying capability of electrodes on the surface of the working portion 11, thereby improving the reliability of operation of the electrodes.

Other structures, materials of individual portions, and connection relationships among the portions of the electrode of a piezo film ultrasonic transducer according to the second embodiment of the present invention are just identical to or similar to those described in the first embodiment of the present invention, and thus will not be further described herein.

A third embodiment of the present invention further provides an electrode of a piezo film ultrasonic transducer. The third embodiment of the present invention differs from the second embodiment in that, the electrode of a piezo film ultrasonic transducer includes: a first base plated electrode layer 2 that is plated on a surface of the working portion 11 of the piezo film 1; a first conductive layer 4 coated on a surface of the lead-out portion 12 that is the same as the surface of the working portion 11; and a second base plated electrode layer 3 plated on the other surface of the working portion 11 and the lead-out portion 12 of the piezo film 1. The electrode of a piezo film ultrasonic transducer may further include a second conductive layer 5 coated on the other surface of the second base plated electrode layer 3. The first conductive layer 4 and a region of the second base plated electrode layer 3 that is plated on the lead-out portion 12 are used to connect electrodes of a PCB that includes a drive circuit of the piezo film ultrasonic transducer respectively. The first conductive layer 4 is adapted to introduce a current into or out of the first base plated electrode layer 2; the region of the second base plated electrode layer 3 that is plated on the lead-out portion 12 is adapted to introduce a current into or out of a region of the second base plated electrode layer 3 that is plated on the working portion 11; and polarities of the first base plated electrode layer 2 and the second base plated electrode layer 3 are opposite to each other.

Likewise, because a conductive layer is coated on a surface of the lead-out portion 12, the reliability of connections between electrodes on the surface of the lead-out portion 12 and the electrodes of the PCB can be improved. Additionally, when the second conductive layer 5 is in the region of the second base plated electrode layer 3 that is on the lead-out portion 12, the reliability of connections between the electrodes on the surface of the lead-out portion 12 and the electrodes of the PCB can be further improved; and when the second conductive layer 5 is in the region of the second base plated electrode layer 3 that is on the working portion 11, the current carrying capability of electrodes on the surface of the working portion 11 can be further increased and thus, the reliability of operation of the electrodes can be improved.

Other structures, materials of portions, and connection relationships among the portions of the electrode of a piezo film ultrasonic transducer according to the third embodiment of the present invention are just identical to or similar to those described in the second embodiment of the present invention, and thus will not be further described herein.

An embodiment of the present invention further provides a piezo film transducer, which includes a piezo film and an electrode of a piezo film ultrasonic transducer that is coated on a surface of the piezo film. The electrode of a piezo film ultrasonic transducer is connected with a PCB that includes a drive circuit of the piezo film ultrasonic transducer, and is the same as the aforesaid electrode of a piezo film ultrasonic transducer.

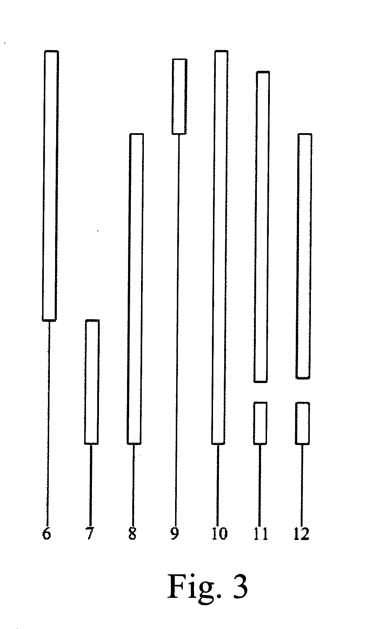

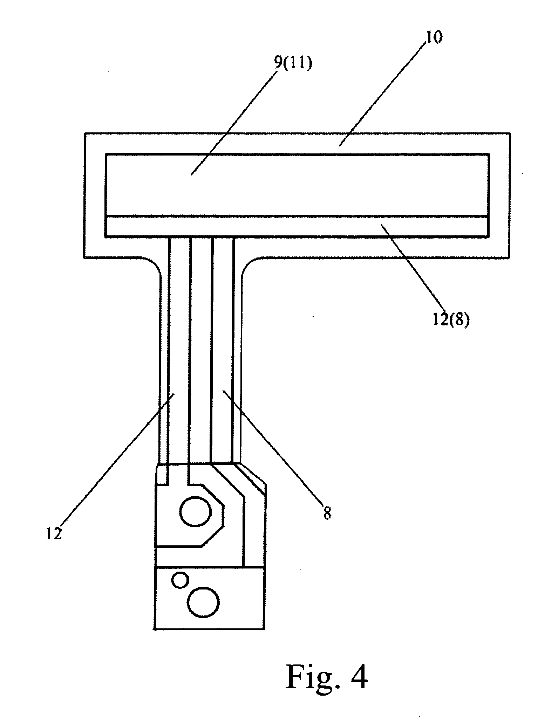

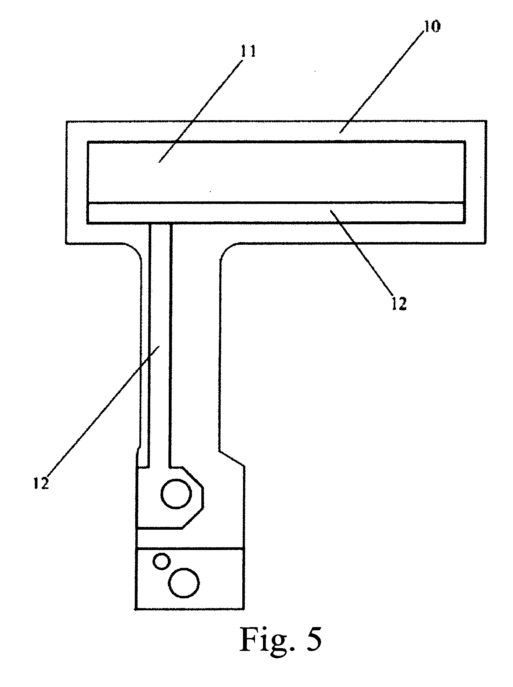

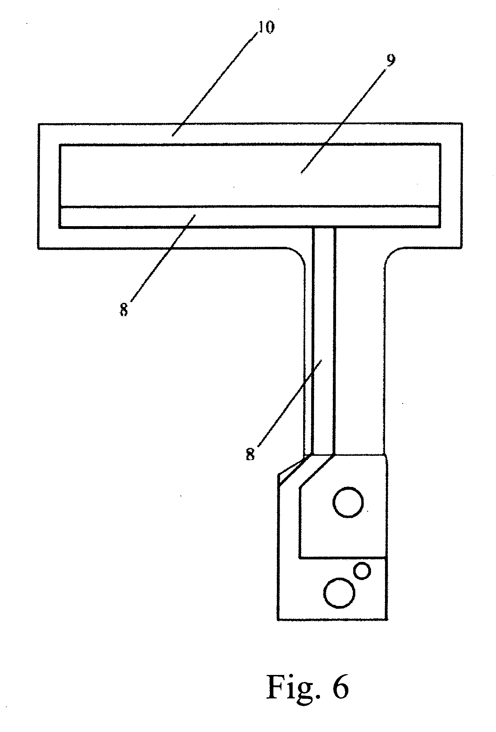

Fig. 3 is a schematic structural view illustrating a piezo film and an electrode according to a fourth embodiment of the present invention when being disassembled; Fig. 4 is a schematic view illustrating a surface structure of the piezo film and the electrode according to the fourth embodiment of the present invention; Fig. 5 is a schematic view illustrating a surface structure of a positive electrode in Fig. 4; and Fig. 6 is a schematic view illustrating a surface structure of a negative electrode in Fig. 4. For convenience of description, only those related to the embodiment of the present invention are shown.

The electrode of a piezo film ultrasonic transducer according to the fourth embodiment of the present invention is a typical example of the first embodiment of the present invention. As shown in Fig. 3, 10 represents a piezo film, 9 represents a negative plated layer, 8 represents a negative conductive layer, 7 represents a mylar, 6 represents a protection layer, 11 represents a positive plated layer, and 12 represents a positive conductive layer. As proven by experiments, the electrode of a piezo film ultrasonic transducer that adopts the aforesaid structure can avoid the problems of evaporation, peeling off and failure of the electrode when operating continuously under long-time high-voltage driving conditions.

An embodiment of the present invention further provides a piezo film ultrasonic transducer, which includes a piezo film and an electrode of a piezo film ultrasonic transducer that is coated on a surface of the piezo film. The electrode of a piezo film ultrasonic transducer is connected with a PCB that includes a drive circuit of the piezo film ultrasonic transducer, and is the same as the aforesaid electrode of a piezo film ultrasonic transducer.

Because, after a base electrode layer is plated on a surface of the lead-out portion and the working portion of the piezo film, a conductive layer is coated on the other surface of the electrode layer, the reliability of connections between electrodes on the surface of the lead-out portion and electrodes of a PCB can be improved when the conductive layer is coated to a region of the electrode layer that is on the lead-out portion. Additionally, after a base electrode layer is plated on the working portion of the piezo film, a conductive layer is coated on the other surface of the electrode layer, which increases the current carrying capability of electrodes on the surface of the working portion and thus improves the reliability of operation of the electrodes.

What described above are only preferred embodiments of the present invention but are not intended to limit the scope of the present invention. Accordingly, any alterations, equivalent substitutions and modifications that are made within the spirits and scope of the present invention shall also fall within the scope of the present invention.

## Claims

1. An electrode of a piezo film ultrasonic transducer having a piezo film, the piezo film comprising a working portion and a lead-out portion integrally formed with the working portion, the electrode of a piezo film ultrasonic transducer comprising:
- a first base plated electrode layer that is plated on a same surface of the working portion and the lead-out portion of the piezo film;
- a first conductive layer coated on the other surface of the first base plated electrode layer; and
- a second base plated electrode layer plated on the other surface of the working portion and the lead-out portion,
wherein a region of the first base plated electrode layer and a region of the second base plated electrode layer that are plated on the lead-out portion are used to connect electrodes of a printed circuit board (PCB) that comprises a drive circuit of the piezo film ultrasonic transducer respectively, and the region of the first base plated electrode layer that is plated on the lead-out portion is adapted to introduce a current into or out of a region of the first base plated electrode layer that is plated on the working portion; the region of the second base plated electrode layer that is plated on the lead-out portion is adapted to introduce a current into or out of a region of the second base plated electrode layer that is plated on the working portion; and polarities of the first base plated electrode layer and the second base plated electrode layer are opposite to each other.

2. The electrode of a piezo film ultrasonic transducer of Claim 1, further comprising a second conductive layer coated on the other surface of the second base plated electrode layer.

3. The electrode of a piezo film ultrasonic transducer of Claim 2, wherein the first base plated electrode layer and/or the second base plated electrode layer are formed by forming a plated layer on the surface of the piezo film through vacuum sputtering or chemical plating and then patterning the plated layer into a preset form through use of a laser or through chemical etching.

4. The electrode of a piezo film ultrasonic transducer of Claim 3, wherein when both the first base plated electrode layer and the second base plated electrode layer are a plated layer formed on the surface of the piezo film through vacuum sputtering or chemical plating, the plated layer acting as the first base plated electrode layer and the plated layer acting as the second base plated electrode layer are arranged symmetrically or unsymmetrically with respect to the piezo film.

5. The electrode of a piezo film ultrasonic transducer of Claim 2, wherein the first conductive layer is a conductive substance coated on the other surface of the first base plated electrode layer along a stretching direction of the piezo film or a direction perpendicular to the stretching direction of the piezo film; and the second conductive layer is a conductive substance coated on the other surface of the second base plated electrode layer along the stretching direction of the piezo film or the direction perpendicular to the stretching direction of the piezo film.

6. The electrode of a piezo film ultrasonic transducer of Claim 2, wherein the first conductive layer and/or the second conductive layer are coated by applying silver powders, carbon powders, silver-carbon mixture powders or a conductive glue, or by laminating a conductive rubber, a conductive adhesive tape or a metal foil, or by adhering a conductive rubber, a conductive adhesive tape or a metal foil, or by laminating or adhering a metal foil on a flexible PCB.

7. The electrode of a piezo film ultrasonic transducer of Claim 2, wherein the first conductive layer is coated on the other surface of the first base plated electrode layer through screen printing or spraying; and the second conductive layer is coated on the other surface of the second base plated electrode layer through screen printing or spraying.

8. The electrode of a piezo film ultrasonic transducer of any of Claim 1 to Claim 7, wherein the piezo film is made of a polyvinylidene fluoride (PVDF) polymer.

9. An electrode of a piezo film ultrasonic transducer having a piezo film, the piezo film comprising a working portion and a lead-out portion integrally formed with the working portion, the electrode of a piezo film ultrasonic transducer comprising:
- a first base plated electrode layer that is plated on a surface of the working portion of the piezo film;
- a first conductive layer coated on a surface of the lead-out portion that is the same as the surface of the working portion;
- a second base plated electrode layer plated on the other surface of the working portion; and
- a second conductive layer coated on the other surface of the lead-out portion,
wherein the first conductive layer and the second conductive layer are used to connect electrodes of a PCB that comprises a drive circuit of the piezo film ultrasonic transducer respectively, the first conductive layer is adapted to introduce a current into or out of the first base plated electrode layer, and the second conductive layer is adapted to introduce a current into or out of the second base plated electrode layer; and polarities of the first base plated electrode layer and the second base plated electrode layer are opposite to each other.

10. An electrode of a piezo film ultrasonic transducer having a piezo film, the piezo film comprising a working portion and a lead-out portion integrally formed with the working portion, the electrode of a piezo film ultrasonic transducer comprising:
- a first base plated electrode layer that is plated on a surface of the working portion of the piezo film;
- a first conductive layer coated on a surface of the lead-out portion that is the same as the surface of the working portion; and
- a second base plated electrode layer plated on the other surface of the working portion and the lead-out portion,
wherein the first conductive layer and a region of the second base plated electrode layer that is plated on the lead-out portion are used to connect electrodes of a PCB that comprises a drive circuit of the piezo film ultrasonic transducer respectively, the first conductive layer is adapted to introduce a current into or out of the first base plated electrode layer, the region of the second base plated electrode layer that is plated on the lead-out portion is adapted to introduce a current into or out of a region of the second base plated electrode layer that is plated on the working portion, and polarities of the first base plated electrode layer and the second base plated electrode layer are opposite to each other.
